Europäisches Patentamt

European Patent Office

Office européen des brevets

(19)

(11) **EP 0 804 801 B1**

(12) **FASCICULE DE BREVET EUROPEEN**

(45) Date de publication et mention
de la délivrance du brevet:
**29.01.2003 Bulletin 2003/05**

(51) Int Cl.7: **H01L 21/00**

(21) Numéro de dépôt: **96939148.1**

(22) Date de dépôt: **19.11.1996**

(86) Numéro de dépôt international:
**PCT/FR96/01828**

(87) Numéro de publication internationale:
**WO 97/019464 (29.05.1997 Gazette 1997/23)**

(54) **BOITE DE STOCKAGE D'UN OBJET DESTINE A ETRE PROTEGE D'UNE CONTAMINATION PHYSICO-CHIMIQUE**

**SUBSTRATBEHÄLTER MIT SCHUTZ GEGEN PHYSISCH-CHEMISCHE KONTAMINATION**

**STORAGE BOX FOR AN OBJECT TO BE PROTECTED FROM PHYSICAL/CHEMICAL CONTAMINATION**

(84) Etats contractants désignés:
**AT BE CH DE DK ES FI FR GB GR IE IT LI LU MC NL PT SE**

(30) Priorité: **20.11.1995 FR 9513720**

(43) Date de publication de la demande:
**05.11.1997 Bulletin 1997/45**

(73) Titulaires:
• **COMMISSARIAT A L'ENERGIE ATOMIQUE**
  **75015 Paris (FR)**
• **L'air Liquide, S.A. à Directoire et Conseil de Surveillance pour l'Etude et l'Exploitation des Procédés Georges Claude**
  **75321 Paris Cedex 07 (FR)**

(72) Inventeurs:
• **SPINELLI, Philippe**
  **F-38700 La Tronche (FR)**

• **DOCHE, Claude**
  **F-38640 Claix (FR)**
• **ROSTAING, Jean-Christophe**
  **F-78000 Versailles (FR)**
• **COEURET, François,**
  **Résidence "Les Symphonies"**
  **F-78280 Guyancourt (FR)**
• **SCOTTO D'APOLONIA, Sylvain**
  **F-78280 Guyancourt (FR)**

(74) Mandataire: **Audier, Philippe André et al Brevalex,**
  **3, rue du Docteur Lancereaux**
  **75008 Paris (FR)**

(56) Documents cités:
EP-A- 0 502 790      EP-A- 0 519 784
EP-A- 0 593 366      FR-A- 2 631 346
US-A- 4 904 515

EP 0 804 801 B1

## Description

L'invention concerne une boîte de stockage d'un objet destiné à être protégé d'une contamination physico-chimique.

Plus précisément, l'invention se rapporte au domaine de la fabrication de produits en milieu ultra propre. Cette fabrication utilise la technologie de la salle blanche qui consiste à traiter l'atmosphère dans laquelle le produit est fabriqué. Dans l'industrie agro-alimentaire ou pharmaceutique mais également dans l'industrie de la microélectronique, de nombreux produits sont ainsi fabriqués en atmosphère de salle blanche afin d'éviter les risques de contamination. Dans le domaine de la microélectronique, la contamination est plus particulièrement redoutée dans la fabrication de pièces présentant des géométries très fines et utilisant des couches minces telles que les écrans plats (LCD) ou les capteurs et dans la fabrication des dispositifs semiconducteurs tels que les microprocesseurs ou les mémoires statiques ou dynamiques, etc...

Il existe principalement deux sortes de contamination, à savoir la contamination d'origine particulaire et la contamination d'origine physicochimique.

La contamination d'origine particulaire est due à un dépôt physique sur le produit fabriqué, susceptible d'engendrer des phénomènes physiques. Ainsi, dans le domaine de la microélectronique, par exemple sur les plaques de silicium, de tels dépôts peuvent entraîner des court-circuits ou des coupures de connexion électrique. Dans ce domaine, la taille des géométries actives décroît d'année en année et elle est passée de quelques microns dans les années 1970 à des dimensions submicroniques au début des années 1990. Dans les années à venir, les industriels se sont dotés de moyens techniques permettant de fabriquer des composants électroniques présentant des géométries de 0,2 à 0,5 $\mu$m. Une contamination d'origine particulaire sur de tels composants ne pourra malheureusement pas être évitée en utilisant simplement les techniques traditionnelles de salle blanche.

La contamination d'origine physico-chimique peut être due aux procédés de fabrication eux-mêmes, c'est-à-dire au nettoyage ou au recuit à haute température sous atmosphère chimiquement active, par exemple. Elle peut être également due tout simplement au contact du produit fabriqué, avec son environnement direct par frottement mécanique sur le support du produit ou par interaction avec l'atmosphère environnant le produit par exemple l'oxydation durant le stockage entre deux étapes du procédé.

Pour éviter la contamination, deux voies différentes sont actuellement utilisées, à savoir le contrôle de l'environnement dans l'atelier de fabrication ou le contrôle sélectif de l'environnement du produit.

Le contrôle de l'environnement dans l'atelier de fabrication consiste à traiter toutes les conditions d'environnement concernant les équipements de fabrication, les produits fabriqués et les opérateurs humains. Cette solution est la plus couramment utilisée. Toutefois, du fait de la présence de l'opérateur humain, source d'une importante contamination aussi bien chimique que particulaire, cette technique est limitée à une propreté d'équivalent de classe de l'ordre de 0,5 à 1. (La classe 1 correspond à la présence de moins de une particule dont le diamètre est supérieur à 0,5 $\mu$m par pied cube : Norme Federal Standard 209c, "Airborne Particulate Cleanliness Classes in Clean Rooms and Clean Zones"). La qualité d'un tel type d'environnement est difficilement compatible avec la fabrication de couches minces présentant des géométries inférieures à 0,20 $\mu$m.

Par ailleurs, dans ce type d'atelier de fabrication où la totalité de l'atmosphère est contrôlée, le produit fabriqué est généralement transporté dans une boîte ou dans un conteneur assurant une bonne protection contre la contamination particulaire mais une médiocre étanchéité avec l'atmosphère environnante. De ce fait, le gaz de l'atmosphère de l'atelier, pollué par l'opérateur humain, a tendance à diffuser à travers la paroi du conteneur ou de la boîte, et entraîne une contamination chimique importante.

Le contrôle sélectif de l'environnement du produit consiste à optimiser uniquement les conditions d'environnement autour du produit fabriqué. Dans ce cas, le produit est placé à l'intérieur d'un conteneur dont l'atmosphère interne est exempte de contamination particulaire. L'avantage de cette solution est qu'on arrive théoriquement à un système répondant à de bien meilleures spécifications en termes de contamination chimique puisque le produit fabriqué n'est plus en contact avec l'air environnant et que l'opérateur humain n'est alors plus une source de contamination particulaire et chimique. Le contrôle de l'environnement du produit pendant les phases de transport et de stockage ayant lieu au cours de son procédé de fabrication est donc rendu beaucoup plus aisé et la contamination chimique dépend alors principalement des performances d'imperméabilité du conteneur.

Dans le domaine de la microélectronique et de la fabrication des plaquettes de silicium, cette solution est appelée SMIF (Standard Mechanical InterFace).

Dans la demande de brevet FR 2 697 000, il a également été envisagé de réaliser une boîte plate de confinement, active, contrôlant l'environnement du produit pendant les phases d'ouverture et de stockage de ladite boîte. Plus précisément, cette boîte est munie d'un bloc aéraulique comportant un diffuseur débouchant à l'intérieur de ladite boîte et susceptible d'être relié à un moyen d'alimentation en gaz inerte tel que de l'azote par exemple.

Dans le domaine plus particulier de la microélectronique, la boîte de stockage d'un produit tel qu'une plaquette de silicium, par exemple, doit actuellement répondre aux spécifications suivantes :

- faible coût de fabrication unitaire,
- interdiction d'utiliser des matériaux polluants tels que l'aluminium, le fer ou l'acier inoxydable par exemple,
- bonne conduction électrique afin d'éviter les problèmes liés à la décharge d'électricité statique à travers le produit transporté,
- faible taux de dégazage dans le temps,
- nettoyage aisé,
- bonne résistance mécanique, et
- faible poids permettant une manipulation humaine.

Pour répondre à ces critères, la quasi-totalité des boîtes de stockage est fabriquée en matière plastique, par exemple en polycarbonate ou en polypropylène. Si ces matériaux répondent aux critères exposés précédemment, il est prouvé qu'ils ne répondront pas aux exigences futures en matière de perméabilité aux agents contaminants dont la diffusion à travers les matières plastiques est rapide, même à température ambiante.

Dans la demande de brevet US-A-4 904 515 il a été envisagé de réaliser un organe de support an Si-SiC pour le traitement thermique d'une plaquette de silicium, l'organe ayant une couche de protection en $SiO_2$.

L'invention a pour but de mettre au point une boîte de stockage répondant aux spécifications précitées et résolvant les problèmes de l'art antérieur. A cet effet, elle concerne une boîte de stockage d'un objet destiné à être protégé d'une contamination physico-chimique. Les parois de cette boîte sont réalisées en matière plastique.

Selon la partie caractérisante de l'invention, la surface interne et/ou la surface externe des parois de cette boîte est revêtue d'au moins une couche de protection réalisée dans un matériau de formule générale :

$$SiO_xN_yH_t,$$

où au moins un de x ou de y est supérieur à 0, et t est inférieur à x et/ou à y,
x et y se situent préférentiellement dans les gammes suivantes :

$$0<x<2$$

$$0\leq y<0{,}4$$

Plus préférentiellement, x se situe dans la gamme comprise entre 0,3 et 1,8.

La contribution de l'hydrogène à la composition $SiO_xN_yH_t$, sera le plus souvent très faible, provenant le plus souvent essentiellement du précurseur gazeux du silicium utilisé pour effectuer le dépôt, qui est en général une molécule contenant de l'hydrogène.

t est donc en tout état de cause inférieur à au moins l'un des paramètres x, y et seulement à x quand on se trouve dans un cas où y est nul (pas de contribution azotée au matériau).

Grâce à ces caractéristiques de l'invention, on obtient une boîte de stockage dans laquelle la contamination chimique induite par la diffusion des gaz à travers la paroi en matière plastique est réduite de façon très importante.

Dans le cas où le dépôt est réalisé sur la paroi interne de la boîte, la contamination chimique d'origine organique due au dégazage propre des parois en matière plastique vers l'intérieur de la boîte maintenue en dépression, est réduite. Par ailleurs, on améliore également l'état de surface de l'intérieur de la boîte et on facilite son nettoyage. Enfin, on améliore également la résistance mécanique de la surface interne de la boîte ainsi traitée et l'on diminue la contamination particulaire engendrée mécaniquement par les chocs ou les rayures.

De préférence, la couche de protection est déposée sur la ou lesdites surface(s) de la boîte par dépôt chimique en phase vapeur assisté par plasma, procédé connu sous la terminologie anglaise "Plasma Enhanced Chemical Vapor Deposition" (PECVD).

Cette technique permet d'effectuer des dépôts homogènes de faible épaisseur sur une matière plastique. L'épaisseur de la couche de protection est avantageusement d'au moins 0,1 µm. L'épaisseur minimale de la couche qu'il convient de réaliser est en fait, au cas par cas, imposée d'une part par des spécifications liées à la perméation, d'autre part par la nécessité d'une résistance mécanique.

Selon une mise en oeuvre avantageuse de l'invention, l'épaisseur de la couche est supérieure ou égale à 1 µm, et encore plus préférentiellement située dans la gamme de 2 à 3 µm.

Ces procédés de dépôt chimique en phase vapeur assisté par plasma (PECVD) sont décrits notamment dans les documents FR 2 631 346, EP 502 790, et EP 519 784.

Le réacteur et les procédés décrits dans ces brevets ont été développés pour obtenir des couches de densité élevée (peu ou pas de structures colonnaires ou granulaires) en opérant à température quasi ambiante. En effet, si une matière plastique telle que le polycarbonate ne subit de modifications irréversibles qu'à partir de 115 à 120°C, la couche inorganique sera en général fissurée et/ou délaminée bien avant cette limite suite à la très forte contrainte thermique appliquée à l'interface du fait de la dissymétrie importante des coefficients de dilatation (rapport 10 à 20). En pratique, on évite donc de travailler à des températures de substrat supérieures à 60°C.

On utilise généralement des plasmas de haute densité et il est nécessaire dans la plupart des cas de refroidir la surface de l'élément de la boîte de stockage sur lequel on réalise le dépôt, en maintenant le porte-boîte (en contact avec la face opposée au dépôt) à une température de l'ordre de 10 à 20°C.

Un autre aspect particulier important de ces procédés est le contrôle du bombardement ionique du substrat. Comme on opère à basse température, il faut apporter de l'énergie non thermique sous forme d'impact cinétique des ions pour assister la migration et le réarrangement des atomes se condensant sur la surface. Ce n'est qu'à cette condition que l'on obtient des couches de microstructure dense offrant de bonnes propriétés fonctionnelles (dureté, inertie physicochimique, imperméabilité, ...).

Enfin, l'adhésion des couches inorganiques sur la boîte de stockage doit être réellement excellente pour toutes les applications des polymères ainsi protégés. Dans le cas présent, la boîte doit pouvoir être nettoyée périodiquement en bain ultrasonique liquide pendant toute sa durée de vie. Il s'agit là d'un critère très sévère. Le procédé décrit dans la demande FR 2,631,346 permet de réaliser des revêtements qui résistent remarquablement au nettoyage ultrasonique. Ce procédé consiste en la succession d'un plasma d'argon, d'un plasma d'ammoniac à 10% dans l'argon, puis d'un plasma de silane très dilué dans l'hélium.

Des travaux menés à bien par les demanderesses ont mis en évidence le fait que les boîtes de stockage dont le revêtement est réalisé par les procédés décrits dans les documents FR 2,631,346, EP 502 790 et EP 519 784 présentent des traces de contamination organique, susceptibles de dégrader la surface de l'objet, (par exemple une plaquette de silicium) stocké dans ladite boîte. Cette contamination se localise toutefois dans la couche superficielle du revêtement de protection. Elle provient essentiellement de l'interaction d'espèces de haute énergie du plasma avec le substrat polymérique, dont on peut identifier les fonctions organiques caractéristiques dans la couche superficielle carbonée.

Selon l'étape considérée dans l'élaboration de l'objet à stocker (par exemple au cours des multiples étapes intervenant dans la fabrication d'un dispositif semiconducteur), cette contamination organique peut incontestablement avoir un rôle néfaste. On se reportera par exemple, pour une meilleure appréhension de ces phénomènes, à la publication de W. Vandervorst et al. dans les "Proceedings du 2nd International Symposium on Ultra Clean Processing of Silicon Surfaces, Leuven, Belgium, September 1995".

Il est apparu intéressant aux Demanderesses de pouvoir disposer d'une méthode permettant de réaliser le retrait de cette contamination carbonée superficielle. Les travaux supplémentaires menés à bien pour apporter une solution technique à ce problème ont démontré qu'il est possible d'obtenir un tel résultat par la réalisation d'une étape de gravure plasma, préférentiellement immédiatement après la phase de dépôt du revêtement SiOxNyHt précédemment décrite, et dans le même réacteur.

L'invention concerne également un procédé de traitement d'une boîte de stockage d'un objet destiné à être protégé d'une contamination physico-chimique dont les parois sont réalisées en matière plastique, selon lequel on effectue sur la surface interne et/ou la surface externe de ses parois, le dépôt d'au moins une couche de protection réalisée dans un matériau de formule SiOxNyHt où au moins un de x et de y est supérieur à 0, et t est inférieur à x et/ou à y, selon une technique de dépôt plasma PECVD, x et y se situant préférentiellement respectivement dans les intervalles $0<x<2$, et $0 \leq y<0,4$. Plus préférentiellement, x se situe dans la gamme entre 0,3 et 1,8.

Selon une des mises en oeuvre de l'invention, on procède ultérieurement à une étape de gravure superficielle de la couche de protection précédemment déposée, par mise en contact de la boîte avec un plasma d'un mélange gazeux à base d'oxygène et d'un gaz fluoré.

Le gaz fluoré sera avantageusement choisi parmi $SF_6$ et $NF_3$.

Comme il n'existe pas de contrainte sur la sélectivité, on se place dans des conditions donnant la vitesse d'attaque la plus élevée. On peut pour cela s'inspirer des techniques rapportées dans la littérature concernant la gravure de $SiO_2$ par un plasma de $SF_6$. Dans ce cas, la gravure n'est pas spontanée et nécessite un bombardement de la surface par des ions accélérés issus du plasma. Cet effet est obtenu, de la même manière que dans le cas du procédé de dépôt de couches, en appliquant au porte-substrat métallique sur lequel repose la face arrière de l'élément de la boîte de stockage en polycarbonate sur lequel on procède à l'opération de gravure, une polarisation radiofréquence, typiquement à 13,56 MHz. Par effet d'autopolarisation, il apparaît une différence de potentiel continue négative entre le plasma et la surface de l'échantillon.

Précisément, les résultats disponibles dans la littérature, à propos de la gravure de $SiO_2$ par $SF_6$, montrent qu'une vitesse d'attaque maximale est obtenue pour des pressions partielles de $SF_6$ de 1 à 10 millitorr (0,13 Pa à 1,3 Pa), avec une énergie des ions de l'ordre de 100 eV. Il n'est donc pas utile de travailler dans des conditions où cette énergie est sensiblement plus élevée.

La pression partielle d'oxygène dans le mélange de gravure peut être choisie dans une gamme relativement large sans s'écarter beaucoup des conditions optimales. Le problème de l'oxydation du polycarbonate (risque de brunissement) ne se pose pas ici puisque la boîte est déjà recouverte de silice.

Plus la concentration en oxygène dans le mélange est élevée, plus la vitesse de gravure l'est également. Une concentration en oxygène se situant dans la gamme de 10 à 80% convient dans la plupart des cas.

L'expérience montre que le plasma $SF_6/O_2$ est d'une excellente efficacité pour attaquer la couche superficielle qui est un mélange de $SiO_2$ ou $SiO_x$ et de fractions organiques.

Il est préférable de prévoir un moyen de contrôle de la profondeur gravée afin de ne retirer que l'épaisseur de la couche superficielle carbonée. A cet effet, on peut étalonner la vitesse d'attaque et arrêter le traitement après un temps fixé, (par sûreté sensiblement majoré par rapport à la valeur nominale, ce qui conduit à une surgravure). On peut aussi asservir le procédé sur un moyen de détection de fin d'attaque, par exemple une mesure optique in-situ.

Les essais ont été effectués dans le réacteur microonde à onde de surface décrit dans FR 2 677 841. Dans ce type de réacteur, dont la particularité est ici que le substrat se trouve dans la très proche post-décharge, il n'est pas indiqué d'injecter directement du $SF_6$ dans le tube à onde de surface. En milieu halogéné, le champ microonde énergétique de l'onde de surface donne en effet lieu à un phénomène d'attaque extrêmement rapide de la paroi de ce tube de silice (beaucoup plus rapide que ce ne serait le cas pour un échantillon de silice placé dans le plasma homogène au centre du tube). Cette attaque entraîne rapidement une dévitrification qui peut altérer la tenue mécanique sous vide du réacteur.

En conséquence, la décharge à onde de surface est entretenue uniquement dans un mélange d'oxygène et d'argon. Ce dernier facilite le contrôle de l'extension du plasma dans tout le volume du tube. $SF_6$ est injecté en post-décharge, au voisinage de l'échantillon. Avec des puissances microonde suffisamment élevées, on peut obtenir une densité de plasma très importante permettant une dissociation efficace du $SF_6$ et des concentrations suffisantes en espèces halogénées actives (fluor atomique notamment) au voisinage du substrat.

Les paramètres de procédé sont alors typiquement les suivants :

puissance microonde : 400 watts
autopolarisation continue du porte-substrat par rapport à la masse : -100 V
pression totale : 70 millitorr (9,1 Pa)
débit Ar : 125 $cm^3$ standard/minute
débit $O_2$ : 50 $cm^3$ standard/minute
débit $SF_6$ : 50 $cm^3$ standard/minute.

La vitesse d'attaque obtenue est typiquement de l'ordre de 100 nanomètres/minute. L'opération de retrait de la couche superficielle carbonée prend donc moins d'une minute en moyenne.

Comme il apparaîtra clairement à l'homme du métier, le choix du réacteur utilisé pour réaliser le dépôt de la (ou des) couche(s) SiOxNyHt ou bien pour réaliser la gravure de la contamination organique est important.

Outre les exemples de réacteur déjà cités, il convient de signaler la possibilité de réaliser le dépôt ou la gravure à l'aide d'un réacteur radiofréquence de type diode planaire tel que celui décrit dans le document JP-05/202211, ou dans un réacteur micro-ondes basé sur un applicateur de type guide à fuites, tel que celui décrit dans le document US-A-4,893,584 ou encore dans certains réacteurs plasma tout particulièrement adaptés au traitement de substrats de taille sensiblement supérieure à 10 $cm^2$, éventuellement de forme gauche, tels que les réacteurs basés sur le concept d'excitation plasma micro-ondes par résonance cyclotronique électronique répartie uniforme (UDECR) tel que celui décrit dans le document EP-A-0 496 681.

On pourra également se reporter aux travaux relatifs à la réalisation par PECVD de couches de silice amorphe de très grande uniformité dans un tel réacteur de type UDECR, rapportés dans l'article de J.C. Rostaing et al. publié dans Proc. Int. Conf. on Metallurgical Coatings and Thin Films, San Diego, Ca., USA, 24-28 April 1995.

L'invention sera mieux comprise à la lecture de la description suivante d'un mode de réalisation de l'invention donné à titre d'exemple illustratif et non limitatif, cette description étant faite conjointement avec les dessins suivants, dans lesquels :

- la figure 1 illustre une boîte de stockage selon l'invention, et
- la figure 2 est un graphique illustrant la variation de la concentration en oxygène à l'extérieur et à l'intérieur d'une boîte selon l'invention.

On donne ci-après un mode de réalisation de l'invention.

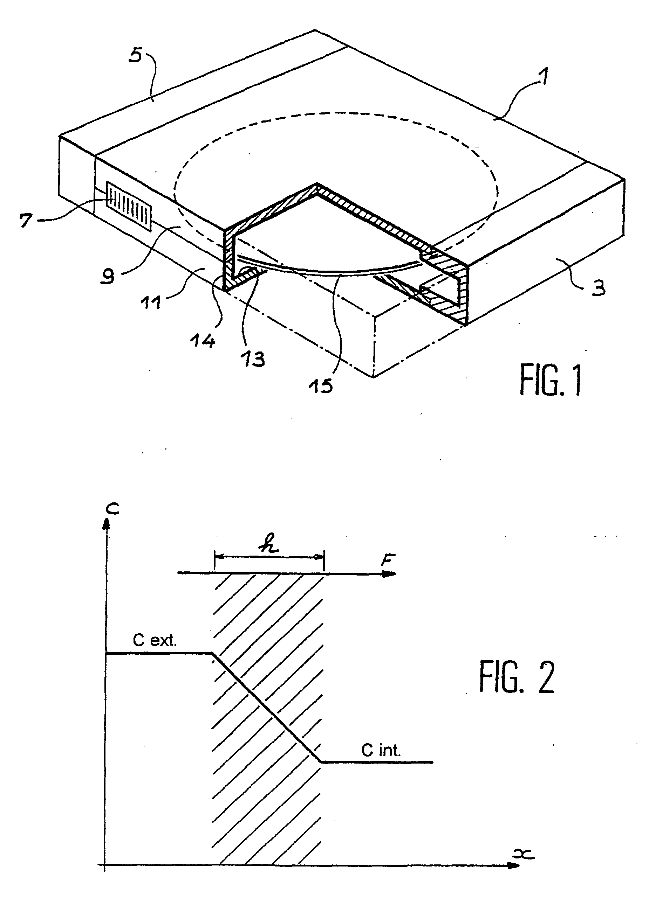

Comme illustré sur la figure 1, la boîte de stockage selon l'invention comprend un corps 1, une porte 3 et de façon facultative un bloc aéraulique 5 permettant de diffuser un gaz inerte à l'intérieur du volume de la boîte et un code d'identification 7 permettant de mentionner des indications concernant le contenu de ladite boîte. Le corps 1 est avantageusement constitué de deux demi-coques 9, 11 en U réalisées en matière plastique par exemple en polycarbonate ou en polypropylène d'une épaisseur de 2 mm.

Le dépôt de la couche de protection 13, 14 s'effectue respectivement sur -les parois interne et externe de la boîte 1 avant l'assemblage des deux demi-coques 9, 11. Ces deux demi-coques sont assemblées par exemple avec une colle époxy ou sont soudées, sauf le bloc aéraulique 5 qui est emboîté sur le reste de la boîte 1. Le dépôt de la couche de protection 13 est également réalisé sur les éléments bloquant et portant l'objet 15 présent à l'intérieur de la boîte, par exemple des picots ou des tiges, (ceux-ci ne sont pas représentés sur la figure 1). De tels éléments sont toutefois facultatifs.

A titre d'exemple illustratif, une boîte de stockage destinée à contenir une plaquette de silicium présentant une dimension de 200 mm de diamètre et de 725 µm d'épaisseur, présente les dimensions approximatives :

Dimensions extérieures :

longueur : 240 mm
largeur : 240 mm
épaisseur : 19 mm

Dimensions intérieures :

longueur : 230 mm
largeur : 210 mm
épaisseur : 9 mm

Le dépôt de la couche de protection 13 est effectué sur les parois internes des demi-coques 9, 11' constituant la boîte, dans un réacteur UDECR tel que décrit dans la publication de J.C. Rostaing et al. précitée. Ce réacteur permet de déposer une fine couche d'oxyde et/ou de nitrure et/ou d'oxynitrure de silicium à partir d'un plasma micro-onde excité à la fréquence de 2,45 GHz. Ce réacteur est alimenté avec les gaz précurseurs suivants :

- pour le silicium : le silane ($SiH_4$), $Si_2H_6$ ou $Si_3H_8$ ou les halogénosilanes $SiX_nH_{4-n}$, (avec X représentant le chlore ou le fluor et $n \leq 4$),
- pour l'oxygène : $O_2$,
- pour l'azote, $N_2$, $NH_3$ ou $N_2O$.

La pression à l'intérieur du réacteur est inférieure à 10 mTorr (1,33 Pa). La température de surface du substrat ne dépasse pas 100°C afin de ne pas dégrader les qualités de surface de celui-ci. Les qualités d'adhésion de la couche de protection 13 à la surface de la boîte 1 en matière plastique peuvent être améliorées par une exposition préalable de ladite surface, à un plasma d'argon, un exemple d'un tel prétraitement étant décrit dans FR-A-2 631 346.

Le tableau 1 présente un exemple typique des critères exigés pour obtenir les performances du revêtement de la boîte.

Tableau 1

| Caractéristiques | | Normes |
|---|---|---|
| Perméabilité à $O_2$ | $<10^{-15} cm^2/s$ | |
| Résistance de surface | $<10^9 \Omega/^2$ | ASTM D-257 |
| Décharge électrostatique | $<3s$ | MIL B-81705B |
| Rugosité : Ra | $<0,2 \mu m$ | |
| Résistance traction/cisaillement | $>1 N/mm^2$ | |
| Transmittance | $>75\%$ | ASTM D-1003 |

Tableau 1   (suite)

| Caractéristiques | | Normes |
|---|---|---|
| Propriétés inactiniques | Coupure à 0,45 µm | |
| Dureté Knoop (charge 0,1 kg) | 200 N/mm$^2$ | |
| Dureté Vickers | 120 N/mm$^2$ | |
| Epaisseur | <10 µm | |
| Durée de vie | 5 ans | |

La figure 2 illustre la contamination observée par diffusion gazeuse à travers les parois d'une boîte standard de stockage d'une plaquette de silicium, à température ambiante. L'abscisse x représente le sens de l'épaisseur de la paroi, h représente l'épaisseur de la paroi de la boîte et C représente la concentration en élément polluant.

D'après la première loi de Fick, (voir "Procédés de séparation par membrane", J.P. Brun, Université de Paris XII, Masson, 1989), le flux F de matière passant à travers la paroi de la boîte de stockage est donné par la formule suivante : F=-Div C, soit par unité de section F=-D.dC/dx, D représentant le coefficient de diffusion.

En supposant que le changement de concentration reste très faible dans la boîte et n'affecte donc pas l'équilibre des concentrations dans l'épaisseur de la paroi, on peut considérer que la concentration intérieure ($C_{int}$) est très inférieure à la contamination extérieure ($C_{ext}$). En conséquence, on peut estimer que par unité de section F=-D$\Delta$C/$\Delta$x.

La variation de concentration pendant l'intervalle de temps t à l'intérieur d'une boîte est donnée par le flux rentrant F par unité de section S, divisé par le volume du conteneur, soit :

$$C_{int}=F.S/V.t.$$

Par ailleurs, en partant de l'hypothèse de départ que le contaminant considéré est l'oxygène contenu dans l'air extérieur ($C_{ext}\approx21\%$) et qu'à t=0 la concentration en oxygène $C_{O_2}$ sur la paroi intérieure de 1a boîte est nulle, on peut considérer que la concentration en oxygène dans la boîte au bout d'un temps t est donnée par l'expression suivante :

$$C_{O_2}=C_{ext}.S.D.t/V.h$$

où S représente la surface totale des parois internes de la boîte, D représente le coefficient de diffusion de l'oxygène dans le matériau considéré à une température donnée, V représente le volume de la boîte, et h représente l'épaisseur des parois.

On donne ci-après deux exemples numériques illustrant les avantages de l'invention.

**1°) Exemple comparatif : boîte en polycarbonate sans couche protectrice**

D = 21.10$^{-9}$cm$^2$.s$^{-1}$, (à 300 K),
V = 320 cm$^3$,
S = 800 cm$^2$,
h = 0,2 cm,
$C_{ext}$ = 21%,

Avec les valeurs précitées et en appliquant la formule précédente, on obtient une concentration en oxygène dans la boîte au bout d'une seconde de $C_{O_2}$=0,21x800x21x10$^{-9}$/320x0,2=55.10$^{-9}$ ou encore 55 ppb.

La spécification de pureté chimique dans une boîte compatible avec une technologie de fabrication de mémoires 1 Gbytes doit être justement inférieure à 50 ppb. Cette valeur est donc atteinte au bout d'une seconde seulement, ce qui signifie qu'une boîte classique en polycarbonate n'est absolument pas compatible avec les spécifications exigées dans le futur pour les technologies de la microélectronique.

2°) **Exemple : boîte en polycarbonate recouverte d'une couche de protection en oxyde de silicium d'une épaisseur de 1 μm :**

Dans ce cas, le coefficient de diffusion D de l'oxygène dans l'oxyde de silicium est donné par l'extension de l'équation de Fick, soit : $D=D_o.e-E/kT$ où E représente l'énergie d'activation de l'oxygène dans l'oxyde de silicium, soit ici 1,16 eV, $D_o$ représente la constante de diffusion de l'oxygène dans l'oxyde de silicium et est égal à $2,7.10^{-4} cm^2/s$ et k représente la constante de Boltzman, $(8,62.10^{-5} eV/°K)$.

Ce qui donne, à température ambiante :

$$D_{300°K}=2,7.10^{-4}.e-(1,16/8,62.10^{-5}.300)=10^{-23} cm^{-2}/s.$$

En reprenant les autres valeurs numériques de l'exemple comparatif, la concentration dans la boîte au bout d'une seconde et en ne considérant que la diffusion de l'oxygène à travers la seule couche d'oxyde de silicium d'une épaisseur de 1 μm, (h=1 μm) est :

$C_{O_2}=C_{ext}.S.D.t/V.h$
$C_{O_2}=0,21.800.10^{-23}/320.10^{-4}=5,25.10^{-20}$ après une seconde.

On constate que pour un conteneur en polycarbonate revêtu d'un dépôt de silice d'une épaisseur de 1 μm, la spécification de 50 ppb serait obtenue après environ $10^{11}s$, c'est-à-dire au bout d'environ 3000 ans.

En pratique toutefois, les couches d'oxyde de silicium déposées par plasma CVD à température ambiante contiennent des défauts qui donnent lieu à des régimes de diffusion plus rapides. Cependant, il existe une marge considérable pour rester dans la gamme des performances requises, c'est-à-dire conserver la spécification de 500 ppb pendant quelques minutes à quelques heures, voire quelques jours à quelques semaines si nécessaire.

Le raisonnement et les ordres de grandeur sont identiques avec des boîtes revêtues d'une couche de nitrure de silicium ou d'oxynitrure de silicium qui peuvent être déposés à basse température et qui sont également de très bonnes barrières de diffusion contre l'oxygène. De même, ces différentes couches de protection empêchent la diffusion à l'intérieur de la boîte de tout autre composé atomique ou molécule contenu dans l'air tel que la vapeur d'eau par exemple.

**Revendications**

1. Boîte de stockage (1) d'un objet (15) destiné à être protégé d'une contamination physico-chimique dont les parois sont réalisées en matière plastique, **caractérisée en ce que** la surface interne et/ou la surface externe de ses parois est revêtue d'au moins une couche de protection (13, 14) réalisée dans un matériau de formule générale $SiO_xN_yH_t$ où au moins un de x et de y est supérieur à 0, et t est inférieur à x et/ou à y.

2. Boîte de stockage selon la revendication 1, **caractérisée en ce que** x est supérieur à 0 et inférieur à 2.

3. Boîte de stockage selon la revendication 1, **caractérisée en ce que** y est supérieur ou égal à 0 et inférieur à 0,4.

4. Boîte de stockage selon l'une des revendications 1 à 3, **caractérisée en ce que** l'épaisseur de la couche de protection (13, 14) est d'au moins 0,1 μm.

5. Boîte de stockage selon la revendication 4, **caractérisée en ce que** l'épaisseur de la couche de protection (13, 14) est d'au moins 1 μm.

6. Boîte de stockage selon la revendication 4, **caractérisée en ce que** l'épaisseur de la couche de protection (13, 14) est comprise entre 2 et 3 μm.

7. Boîte de stockage selon la revendication 1, **caractérisée en ce que** ses parois sont réalisées en polycarbonate ou en polypropylène.

8. Boîte de stockage selon la revendication 1, **caractérisée en ce qu'**elle comprend un bloc aéraulique (5) permettant de réaliser le balayage de l'intérieur de la boîte à l'aide d'un gaz inerte.

**9.** Boîte de stockage selon l'une quelconque des revendications précédentes, **caractérisée en ce qu'**elle est destinée à contenir au moins une plaquette de silicium (15).

**10.** Procédé de fabrication de la boîte de stockage selon l'une quelconque des revendications 1 à 9, **caractérisé en ce que** le dépôt de la couche de protection (13, 14) sur la ou les surfaces des parois de la boîte est effectué par dépôt chimique en phase vapeur assisté par plasma.

**11.** Procédé de fabrication de la boîte de stockage selon la revendication 10, **caractérisé en ce qu'**on effectue une étape de gravure superficielle de la couche de protection précédemment déposée, par mise en contact de la boîte avec un plasma d'un mélange gazeux à base d'oxygène et d'un gaz fluoré.

**12.** Procédé de fabrication de la boîte de stockage selon la revendication 11, **caractérisé en ce que** le gaz fluoré est choisi parmi $SF_6$ ou $NF_3$.

**Patentansprüche**

**1.** Lagerbehälter (1) mit Wänden aus Kunststoff für einen gegen physikalischchemische Kontamination zu schützenden Gegenstand (15),
**dadurch gekennzeichnet,**
**dass** die Innenoberfläche und/oder die Außenoberfläche dieser Wände mit wenigstens einer Schutzschicht (13, 14) überzogen ist, realisiert aus einem Material mit der allgemeinen Formel $SiO_xN_yH_t$, wo von den Indices x und y wenigstens einer größer als 0 ist und t kleiner als x und/oder als y ist.

**2.** Lagerbehälter nach Anspruch 1, **dadurch gekennzeichnet, dass** x größer als 0 und kleiner als 2 ist.

**3.** Lagerbehälter nach Anspruch 1, **dadurch gekennzeichnet, dass** y größer oder gleich 0 und kleiner als 0,4 ist.

**4.** Lagerbehälter nach einem der Ansprüche 1 bis 3, **dadurch gekennzeichnet, dass** die Dicke der Schutzschicht (13, 14) wenigstens 0,1 µm beträgt.

**5.** Lagerbehälter nach Anspruch 4, **dadurch gekennzeichnet, dass** die Dicke der Schutzschicht (13, 14) wenigstens 1 µm beträgt.

**6.** Lagerbehälter nach Anspruch 4, **dadurch gekennzeichnet, dass** die Dicke der Schutzschicht (13, 14) zwischen 2 und 3 µm enthalten ist.

**7.** Lagerbehälter nach Anspruch 1, **dadurch gekennzeichnet, dass** seine Wände aus Polycarbonat oder Polypropylen sind.

**8.** Lagerbehälter nach Anspruch 1, **dadurch gekennzeichnet, dass** er einen Aeraulikblock (5) umfasst, um das Innere des Behälters mit Hilfe eines inerten Gases spülen zu können.

**9.** Lagerbehälter nach einem der vorangehenden Ansprüche, **dadurch gekennzeichnet, dass** er dazu bestimmt ist, eine Siliciumscheibe (15) aufzunehmen bzw. einzuschließen.

**10.** Verfahren zur Herstellung des Lagerbehälters nach einem der Ansprüche 1 bis 9, **dadurch gekennzeichnet, dass** die Abscheidung der Schutzschicht (13, 14) auf der Oberfläche oder den Oberflächen der Wände des Behälters eine Plasma-unterstützte chemische Gasphasenabscheidung ist.

**11.** Verfahren zur Herstellung des Lagerbehälters nach Anspruch 10, **dadurch gekennzeichnet, dass** man einen Schritt des Oberflächenätzens der vorhergehend abgeschiedenen Schutzschicht durchführt, indem man den Behälter in Kontakt bringt mit einem Plasma aus einer gasförmigen Mischung auf der Basis von Sauerstoff und einem fluorierten Gas.

**12.** Verfahren zur Herstellung des Lagerbehälters nach Anspruch 11, **dadurch gekennzeichnet, dass** das fluorierte Gas ausgewählt wird zwischen $SF_6$ und $NF_3$.

**Claims**

1.  Storage box (1) for an object (15) to be protected against physicochemical contamination and whose walls are made from a plastics material, **characterized in that** the inner surface and/or outer surface of its walls is coated with at least one protective layer (13, 14) made from a material of general formula $SiO_xN_yH_t$, where at least one x and y exceeds 0 and t is below x and/or y.

2.  Storage box according to claim 1, **characterized in that** x is higher than 0 and lower than 2.

3.  Storage box according to claim 1, **characterized in that** y is equal to or higher than 0 and lower than 0.4.

4.  Storage box according to any one of the claims 1 to 3, **characterized in that** the thickness of the protective layer (13, 14) is at least 0.1 μm.

5.  Storage box according to claim 4, **characterized in that** the thickness of the protective layer (13, 14) is at least 1 μm.

6.  Storage box according to claim 4, **characterized in that** the thickness of the protective layer (13, 14) is between 2 and 3 μm.

7.  Storage box according to claim 1, **characterized in that** its walls are made from polycarbonate or polypropylene.

8.  Storage box according to claim 1, **characterized in that** it incorporates an aeraulic unit (5) making it possible to carry out scavenging within the box with the aid of an inert gas.

9.  Storage box according to any one of the preceding claims, **characterized in that** it is intended to contain at least one silicon wafer (15).

10. Process for the production of a storage box according to any one of the claims 1 to 9, **characterized in that** the deposition of the protective layer (13, 14) on the surface or surfaces of the box walls takes place by plasma enhanced chemical vapour deposition.

11. Process for the production of a storage box according to claim 10, **characterized in that** there is a surface etching stage for the previously deposited protective layer, by contacting the box with a plasma of a gaseous mixture based on oxygen and a fluorine gas.

12. Process for the production of the storage box according to claim 11, **characterized in that** the fluorine gas is chosen from among $SF_6$ and $NF_3$.

FIG. 1

FIG. 2